(19)

Europäisches
Patentamt
European
Patent Office
Office européen
des brevets

(11) **EP 1 541 537 B1**

(12) **EUROPEAN PATENT SPECIFICATION**

(45) Date of publication and mention
of the grant of the patent:
**31.12.2008 Bulletin 2009/01**

(51) Int Cl.:
*C04B 35/465* *(2006.01)*     *H01B 3/12* *(2006.01)*
*C08K 3/22* *(2006.01)*

(21) Application number: **04029105.6**

(22) Date of filing: **08.12.2004**

(54) **Dielectric ceramic powder, method for producing the same, and composite dielectric material**

Dielektrisches keramisches Pulver, Verfahren zu dessen Herstellung sowie diekektrisches
Verbundmaterial

Poudre diélectrique céramique, son procédé de fabrication et matériau diélectrique composite

(84) Designated Contracting States:
**AT BE BG CH CY CZ DE DK EE ES FI FR GB GR
HU IE IS IT LI LT LU MC NL PL PT RO SE SI SK TR**

(30) Priority: **10.12.2003 JP 2003412387**

(43) Date of publication of application:
**15.06.2005 Bulletin 2005/24**

(73) Proprietor: **TDK Corporation
Tokyo 103-8272 (JP)**

(72) Inventors:
• **Kanada, Isao
Tokyo 103-8272 (JP)**
• **Sakamoto, Norimasa
Tokyo 103-8272 (JP)**
• **Ozawa, Mio
Tokyo 103-8272 (JP)**

• **Che, Shenglei
Tokyo 103-8272 (JP)**

(74) Representative: **HOFFMANN EITLE
Patent- und Rechtsanwälte
Arabellastrasse 4
81925 München (DE)**

(56) References cited:
**WO-A-03/010092          GB-A- 1 123 806
US-A- 3 367 766          US-A- 4 468 432**

• **DATABASE WPI Section Ch, Week 198635
Derwent Publications Ltd., London, GB; Class
A88, AN 1986-228907 XP002313913 & JP 61
158821 A (SONY CORP) 18 July 1986 (1986-07-18)**
• **PATENT ABSTRACTS OF JAPAN vol. 1997, no.
01, 31 January 1997 (1997-01-31) -& JP 08 231274
A (KYOCERA CORP), 10 September 1996
(1996-09-10)**

EP 1 541 537 B1

**Description**

Field of the Invention

The present invention relates to a dielectric ceramic powder, in particular, a dielectric ceramic powder which can exhibit excellent properties when formed into a composite substrate together with a resin.

Description of the Related Art

Recently, reduction in size and weight, and speedup of communication appliances are eagerly demanded. Particularly, the frequency band of the radio waves, for use in the cellular mobile communication such as digital cellular phones, and in the satellite communication falls in a high frequency band ranging from the megahertz band to the gigahertz band (hereinafter, referred to as "GHz band").

In the rapid development of the communication appliances being used, downsizing and high density mounting have been attempted for the cases, substrates, and electronic elements. For the purpose of further promoting the reduction in size and weight of the communication appliances for the high frequency bands, the materials for the substrates and the like used in communication appliances are required to be excellent (small in dielectric loss) in high frequency transmission properties in the GHz band.

The dielectric loss is proportional to the product of the frequency, the square root of the dielectric constant $\varepsilon$ of the substrate (hereinafter, represented by $\varepsilon^{0.5}$) and the dielectric dissipation factor (hereinafter, represented by $\tan\delta$). Accordingly, for the purpose of reducing the dielectric loss, it is necessary to reduce the $\tan\delta$ of the substrate. In addition, the wavelength of an electromagnetic wave is contracted in a substrate by a factor of $1/\varepsilon^{0.5}$, and hence the larger is the dielectric constant $\varepsilon$, the substrate size can be made the smaller.

From the above, the circuit boards for the downsized communication appliances, electronic appliances, and information appliances used in a high frequency band are required to have such material properties that the dielectric constant $\varepsilon$ is high and also Q value (here, Q is the reciprocal of $\tan\delta$, $Q = 1/\tan\delta$) is high.

As the materials used for such circuit boards, dielectric materials are used as inorganic materials, while fluororesins and the like are used as organic materials. The substrates made of dielectric materials are excellent in the properties of dielectric constant $\varepsilon$ and Q value, but have drawbacks in dimension accuracy and machinability, and have a problem that the dielectric substrates are so brittle that they are easily chipped and cracked. On the other hand, the substrates made of organic materials such as resins and the like have the advantages of excellent moldability and machinability, and high Q value, but have a problem that the dielectric constants $\varepsilon$ are small. Accordingly, recently, for the purpose of obtaining substrates simultaneously having both advantages thereof, composite substrates have been proposed which are formed as composite substances of organic materials and inorganic materials by mixing dielectric materials in resin materials (for example, see Japanese Patent No. 2617639).

Accompanying the advent of such composite substrates, those dielectric materials which are excellent in dispersion properties and packing properties for resin material are demanded. A factor for a dielectric powder to acquire the dispersion properties and packing properties for resin materials is the particle size of the powder. For example, powders produced from the liquid phase by employing a precipitation method, are too fine to acquire the dispersion properties and packing properties for resin materials.

In addition, another factor for powders to acquire the dispersion properties and packing properties for resin materials is the particle shape. Incidentally, in the present specification, a powder signifies an ensemble of particles; when the substance concerned is judged to be appropriately referred to as a powder as being an ensemble of particles, the substance will be referred to as "powder", and when the substance concerned is judged to be appropriately referred to as particles as being units constituting a powder, the substance will be referred to as "particles." Since the powder and the particle share the common fundamental unit, needles to say there are sometimes no substantial differences between the powder and the particle. Accordingly, there are some cases where either the expression of "powder" or the expression of "particles" can be used.

The applicant of the present invention has proposed spherical dielectric powder wherein a sphericity of 0.82 to 1 and the ratio between the 10% diameter and the 90% diameter of the powder is 30 or less, to be dispersed in a resin material (JP-A 2003-151352). Particles close to true spheres, i.e., those having a sphericity of 0.82 to 1, greatly improve their dispersion and packing properties in a resin material to give a composite dielectric material of excellent high-frequency properties. The patent document also discloses that dielectric ceramic particles of narrow particle size distribution and high sphericity allow the mixture with a resin material, i.e., composite dielectric material, to be packed even in the substrate pattern edges.

The dielectric ceramic powder disclosed in JP-A 2003-151352 is produced by supplying the granular powders into a combustion flame, in which they are melted when stayed for a given time and formed into spheres after being cooled. Milling is another method for producing dielectric ceramic powder. This method essentially comprises milling of the fired starting material by jet mill or the like into fine particles. The particles produced by milling have an indefinite shape, and are anticipated to deteriorate fluidity of the mixture with a resin material. A composite dielectric substrate is formed by pressing the sheet of a mixture of dielectric ceramic powder and resin material under heating. The mixture (or resin) for a substrate may not give an accurate electrical circuit pattern on the substrate when it is not sufficiently fluid during the above pressing, because of difficulty in flowing into gaps in the pattern.

SUMMARY OF THE INVENTION

The present invention has been developed to solve these technical problems. It is an object of the present invention to provide a dielectric ceramic powder which can secure fluidity of a mixture thereof with a resin, even when produced by milling. It is another object of the invention to provide a method for producing a dielectric ceramic powder which can secure fluidity of a mixture thereof with a resin. It is still another object of the invention to provide a composite dielectric material comprising the above ceramic powder and a resin.

First, fluidity of a mixture of dielectric ceramic powder and a resin is studied, where the resin is normally a thermosetting resin for a composite dielectric substrate. When the mixture is heated from room temperature, the resin therein decreases in viscosity. Resin decreases in viscosity simply with temperature to a certain level, but turns to increase when temperature reaches its curing temperature. Fluidity is evaluated as the lowest viscosity (lowest melt viscosity) during the thermosetting process. It is found that powder specific surface area affects the lowest melt viscosity.

It is meaningless when the mixture with increased fluidity deteriorates in dielectric properties (dielectric constant $\varepsilon$ and Q value). It is found that a dielectric ceramic powder deteriorates in dielectric properties, in particular Q value, depending on its lattice strain, even when the composition is kept constant.

The present invention has been developed, based on the above findings. The present invention provides a dielectric ceramic powder having a specific surface area of 9 $m^2/cm^3$ or less and lattice strain of 0.2 or less. The dielectric ceramic powder having the specific surface area and lattice strain each controlled in the above range can secure fluidity of the mixture with a resin, even when it is produced by milling to have particles of indefinite shape, and give a composite dielectric material of excellent dielectric properties.

The dielectric ceramic powder of the present invention preferably has the largest particle size of 10$\mu$m or less, because the larger particles may increase surface roughness of the composite dielectric substrate in which they are present, when the substrate is thin.

The dielectric ceramic powder of the present invention is preferably of a composite perovskite, in particular of (Sr, Ca)TiO$_3$- or (Ba, Sr, Ca)TiO$_3$-based one, because it gives a higher dielectric constant ($\varepsilon$) than other compositions.

The present invention also provides a method for producing a dielectric ceramic powder, which comprises a firing step in which a starting material for the dielectric ceramic powder is kept at a given temperature level for a given time, and jet milling step in which the fired material is milled, wherein each of these steps is repeated at least twice. Repeating these steps at least twice can control specific surface area and lattice strain each within the range for the present invention, even when each value obtained by the one firing/milling cycle is beyond the above range. Normally, the starting material to be fired is a calcined material which is obtained by calcining a mixture of raw materials, unless the firing step includes the calcining step. In the latter case, the starting material to be fired is a mixture of raw materials.

The fired material is milled by a jet mill for the above method.

Moreover, in the method of the present invention for producing a dielectric ceramic powder, the finely milled material is preferably heat-treated at 800 to 1200°C for improved dielectric properties. The heat treatment is preferably conducted after the final milling step, in the present process comprising the firing and milling steps carried out at least twice.

The present invention also provides a composite dielectric material in which the dielectric ceramic powder of the present invention is incorporated. It comprises the dielectric ceramic powder having a specific surface area of 9 $m^2/cm^3$ or less and lattice strain of 0.2 or less, dispersed in a resin.

The dielectric ceramic powder can be composed of particles of indefinite shape, produced by milling. The composite dielectric material of the present invention can secure fluidity even with indefinite shape of the particles.

The dielectric ceramic powder preferably has the largest particle size of 10 $\mu$m or less, since the larger particles may cause difficulty in producing a thin substrate.

The dielectric ceramic powder is preferably of a composite perovskite, in particular of (Sr, Ca)TiO$_3$- or (Ba, Sr, Ca)TiO$_3$ one.

The dielectric ceramic powder of the present invention can secure fluidity of the mixture with a resin to give a composite dielectric substrate of excellent moldability and dielectric properties.

The method of the present invention for producing a dielectric ceramic powder can control specific surface area and lattice strain each within the range for the present invention, even when each value obtained by the one firing/milling cycle is beyond the above range.

BRIEF DESCRIPTION OF THE DRAWINGS

FIG. 1 shows an X-ray diffraction pattern, by which a lattice strain of the powder prepared in one embodiment of the present invention is determined;
FIG. 2 is a graph, by which a lattice strain of the powder prepared in one embodiment of the present invention is determined;
FIG. 3 shows compositions and process parameters of the dielectric ceramic powders prepared in example 1; and
FIG. 4 shows powder properties (specific surface area, lattice strain, etc.), dielectric constants ($\varepsilon$) and Q values of the dielectric ceramic powders prepared in example 1.

DETAILED DESCRIPTION OF THE PREFERRED EMNODIMENTS

The embodiments of the present invention are described.
The dielectric ceramic powder of the present invention has a specific surface area (SSA) of 9 $m^2/cm^3$ or less. As discussed earlier, specific surface area of the dielectric ceramic powder affects the lowest melt viscosity of the powder/ resinmixture. The substrate can be molded moreeasily as melt viscosity of the mixture decreases, i.e., as mixture fluidity increases. The inventors of the present invention have found that the lowest melt viscosity is preferably 500 Pa·s or less for production of the substrate. The lowest melt viscosity exceeds 500 Pa·s as specific surface area of the powder exceeds 9 $m^2/cm^3$, as demonstrated in EXAMPLE described later. Therefore, specific surface area of the dielectric ceramic powder of the present invention is set at 9 $m^2/cm^3$ or less. The specific surface area is preferably 8.5 $m^2/cm^3$ or less, more preferably 8 $m^2/cm^3$ or less.
Specific surface area of the powder of the present invention is converted to the value per unit volume, estimated by the general formula (1) in consideration that the particles having different densities being compared with each other:

$$\text{SSA} \ (m^2/cm^3) \ = \ \text{SSA} \ (m^2/g) \times \rho \, (g/cm^3) \qquad (1)$$

wherein,
SSA ($m^2/g$): Particle specific surface area determined by the BET(Brunauer-Emmett-Teller) method
$\rho$ : Particle density determined using a pycnometer
The dielectric ceramic powder of the present invention has a lattice strain of 0.2 or less. Lattice strain of the powder affects Q value of the composite material: Q value is low at below 300, when powder lattice strain exceeds 0.2. The dielectric ceramic powder of the present invention preferably has a lattice strain of 0.18 or less, more preferably 0.16 or less.
Lattice strain of the powder of the present invention is determined by the Hall method, that is, by the general formula (2):

$$\beta \cos\theta/\lambda \ = \ 2\eta \, (\sin\theta/\lambda) \ + \ K/D \qquad (2)$$

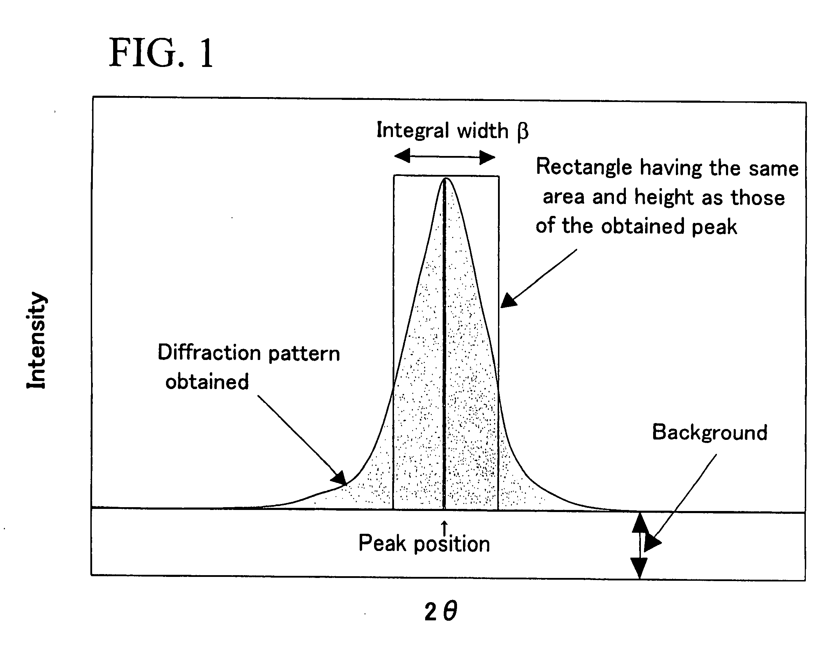

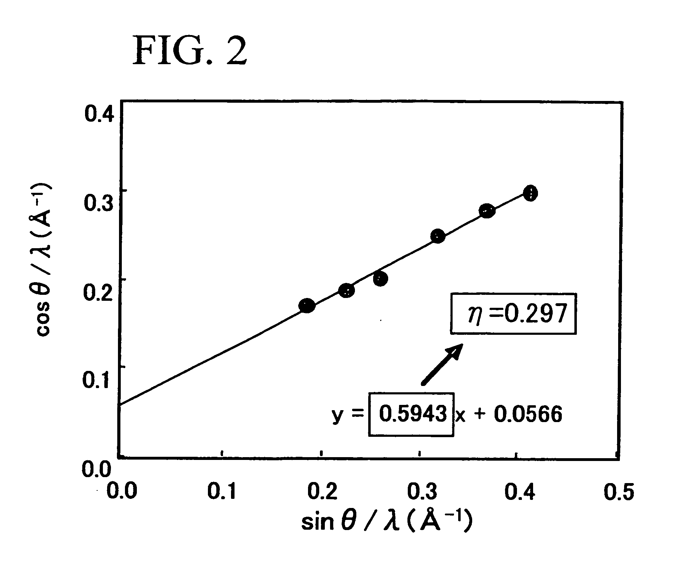

wherein,
$\beta$: integral width
$\theta$: Bragg angle of diffraction line
$\eta$: lattice strain
D: crystallite size
K: Schrrer constant
$\lambda$: X-ray wavelength (CuK$\alpha_1$, 1.54056Å)
In the general formula (2), lattice strain $\eta$ is determined by finding the peak position ($2\theta$) and integral width ($\beta$) of the peak from the powder X-ray diffraction pattern shown in FIG. 1, and dividing by 2 the slope of the straight line in the plot shown in FIG. 2.
The analyzer and measurement conditions are summarized below:

Analyzer: RINT 2500 (manufactured by Rigaku Mechatronics) Current-voltage: 50 kV-300 mA, $2\theta$: 20 to 85°, Scanning rate: 1°/minute, Sampling interval: 0.002°, Divergence slit: 1/2°, Scattering slit: 1/2°, Receiving slit: Open

The dielectric ceramic powder of the present invention preferably has the largest particle size of 10 $\mu$m or less, more preferably 8 $\mu$m or less, still more preferably 6 $\mu$m or less. The particle having a size above 10 $\mu$m is too large for the powder/resin composite substrate having a thickness of around 40$\mu$m or so. Therefore, it is set at 10 $\mu$m or less.

The ceramics for the dielectric ceramic powder of the present invention include those based on alumina, Ba-Nd-Ti, Ba-Sm-Ti, barium titanate-tin, lead-calcium, titanium dioxide, barium titanate, lead titanate, strontium titanate, calcium titanate and bismuth titanate, magnesium titanate. The other useful ceramics include those based on $CaWO_4$, $(Sr, Ca)TiO_3$, $(Ba, Sr, Ca)TiO_3$, $Ba(Mg, Nb)O_3$, $Ba(Mg, Ta)O_3$, $Ba(Co, Mg, Nb) O_3$ and $Ba (Co, Mg, Ta)O_3$. Of these, those based on $(Sr, Ca)TiO_3$ or $(Ba, Sr, Ca)TiO_3$ are more preferable.

The dielectric ceramic powder of the present invention can be produced by firing a raw material powder and milling the obtained fired material. For example, a raw material powder is weighed and mixed to have a desired composition, the mixture is calcined. Thereafter, one or more additives are added to the obtained calcined material, which is then milled, the obtained milled powder is fired and the obtained fired material is milled. When the firing step includes the calcining step, the mixture of raw material powders may be directly fired, as discussed earlier. In this case, it is necessary to control the operating conditions in the production process in such a way to have specific surface area and lattice strain of a powder each in the range for the present invention. This point is discussed below.

First, both powder specific surface area and lattice strain tend to increase as firing temperature increases. Specific surface area exceeds 9 m$^2$/cm$^3$ and lattice strain exceeds 0.2 respectively at a firing temperature of 1300°C, as demonstrated in EXAMPLE, described later. It is therefore preferable to keep firing temperature at 1300°C or lower, more preferably at 1250°C or lower.

The material added one or more additives may not have a specific surface area of 9 m$^2$/cm$^3$ or less and lattice strain of 0.2 or less, even when fired at 1300°C or lower. In this case, repeating the firing and milling steps is an effective procedure. Even when the powder fired and milled once has a specific surface area above 9 m$^2$/cm$^3$ and lattice strain above 0.2, it can have a specific surface area and lattice strain decreased to 9 m$^2$/cm$^3$ or less and to 0.2 or less when fired and milled again. Repeating the firing/milling cycles twice is sufficient, as demonstrated in EXAMPLE, described later. However, the cycles may be repeated 3 or more times, needless to say.

The firing and milling conditions may be kept constant or different cycle by cycle. For example, the powder fired at 1100°C for 4 hours in the first firing step may be fired under the same conditions or at 1150°C for 3 hours in the second step. Similarly, it may be milled by different methods or for different time step by step.

A milling machine may be selected from various ones for the milling step. However, it is recommended to select an adequate one to secure a powder specific surface area of 9 m$^2$/cm$^3$ or less while keeping the largest particle size at 10 $\mu$m or less. The milled particles are not uniformly sized, and relatively finer. They should have a larger specific surface area, when further milled. Therefore, it is recommended not to use a milling machine, such as ball mill, which repeatedly mills fine particles. A jet mill is the desired select for the present invention. It generally has a classification capacity to control excessive milling of fine particles, and can easily produce the dielectric ceramic powder having a specific surface area of 9 m$^2$/cm$^3$ or less and the largest particle size of 10 $\mu$m or less. By contrast, when a ball mill is used, the largest particle size exceeds 10 $\mu$m when a specific surface area is 9 m$^2$/cm$^3$ or less and a specific surface area exceeds 9 m$^2$/cm$^3$ when the largest particle size is 10 $\mu$m or less.

It is preferable that the milled powder is heat-treated at 800 to 1200°C for improved dielectric properties. At below 800°C, dielectric properties of the powder may not be sufficiently improved, because of limited effect of reducing the lattice strain. At above 1200°C, on the other hand, the particles may be fired with each other to deteriorate powder fluidity.

The characteristic aspects of the method of the present invention are described above. The common procedures may be used for the other aspects.

Next, a composite dielectric material of the present invention, will be explained.

In a composite dielectric material of the present invention, when the total content of a dielectric ceramic powder and a resin is represented as 100 vol%, the content of the dielectric ceramic powder is 30 to 70 vol%, both inclusive. When the content of the dielectric ceramic powder is smaller than 30 vol% (the content of the resin exceeds 70 vol%), the dimension stability as a substrate is lost, and the dielectric constant $\varepsilon$ is decreased. Namely, little appreciable effect of containing dielectric ceramic powder is found. On the other hand, when the content of the dielectric ceramic powder exceeds 70 vol% (the content of the resin is smaller than 30 vol%), the fluidity is extremely degraded when press molded, so that no dense molded product can be obtained. As a result, there easily occurs decrease in strength, water invasion or the like, leading to degradation of the electric properties. As compared to the case where no dielectric ceramic powder is added, sometimes the Q value is largely decreased. Consequently, the content of the dielectric ceramic powder is set to be 30 to 70 vol%, both inclusive. The preferable content of the dielectric ceramic powder is 30 to 50 vol%, and the more preferable content of the dielectric ceramic powder is 35 to 45 vol%.

The resins which can be used for the composite dielectric material of the present invention include at least one of thermosetting resins of polyolefin-based, unsaturated polyster, vinyl ester, polyimide, bismaleimide-triazine (cyanate ester), polyphenylene ether (oxide), fumarate, polybutadiene and vinyl benzyl resins; or at least one of thermoplastic

EP 1 541 537 B1

resins of aromatic polyester, polyphenylene sulfide, polyethylene terephthalate, polyethylene sulfide, polyethyl ether ketone, polytetrafluoroethylene, polyallylate and graft resins. Moreover, a composite resin of at least one of the above thermosetting resins and at least one of the above thermoplastic resins may be used in combination.

A reinforcing material can be added to a resin of the present invention. A reinforcing material is effective in improving the mechanical strength and the dimension stability, and hence usually a prescribed amount of a reinforcing material is added to the resin in producing a circuit board.

As the reinforcing materials, there can be listed fibrous reinforcing materials or plate-like or granular non-fibrous reinforcing materials. Among the fibrous reinforcing materials, here can be listed inorganic fibers such as glass fiber, alumina fiber, aluminum borate fiber, ceramics fiber, silicon carbide fiber, asbestos fiber, gypsum fiber, brass fiber, stainless fiber, steel fiber, metal fibers, magnesium borate whisker or fiber thereof, potassium titanate whisher or fiber, zinc oxide whisker, boron whisker fiber, and the like; and carbon fiber, aromatic polyamide fibers, aramide fibers, polyimide fibers, and the like. When a fibrous reinforcing material is used, there can be adopted a so-called impregnation method described in Japanese Patent Laid-Open No. 2001-187831. Namely, the point is that a fibrous reinforcing material molded in a sheet shape is immersed in a coating vessel in which the dielectric powder and the resin are mixed to prepare a slurry.

As the non-fibrous reinforcing materials, there can be listed needle-like, plate-like, or granular reinforcing materials which are silicates such as wollastonite, sericite, kaolin, mica, clay, bentonite, asbestos, talc, alumina silicate, pyrophyllite, montmorillonite, and the like; molybdenum disulfide, alumina, silicon chloride, zirconium oxide, iron oxides; carbonates such as calcium carbonate, magnesium carbonate, dolomite, and the like; sulfates such as calcium sulfate, barium sulfate, and the like; calcium polyphosphate, graphite, glass bead, glass microballoon, glass flake, boron nitride, silicon carbide, and silica. These materials may be hollow. When a non-fibrous reinforcing material is used, it only has to be added to a resin.

These reinforcing materials may be used each alone, or can be used in combination with two or more than two kinds of materials thereof, and if need be, can be applied a pretreatment with coupling agents based on silane or titanium. A particularly preferable reinforcing material is glass fiber. As for the type of glass fiber, there is no particular limitation to it, and there can be used those which are generally used in reinforcing resins. The glass fiber to be used can be selected from, for example, chopped strands of long fiber type and short fiber type, chopped strand mat, continuous long fiber mat, cloth-like glass such as fabric, knit fabric, or the like, and milled fiber.

The content of a reinforcing material in a composite dielectric material preferably falls in the range from 10 to 30 wt%, and more preferably from 15 to 25 wt%.

A composite dielectric material of the present invention can be used in a variety of shapes such as film, a molded body in bulk form or in a prescribed shape, a film lamination, or the like. Accordingly, it can be used in electronic equipments and electronic parts for use in the high frequency band. In addition, they can be used for on-board substrates for CPU.

A composite dielectric material of the present invention and a board using thereof can be used suitably in the GHz band, and can have a dielectric constant $\varepsilon$ of 12 or more and a Q value of 300 or more in the case of the 2 GHz band.


EXAMPLE 1

Examples of the present invention are described below.

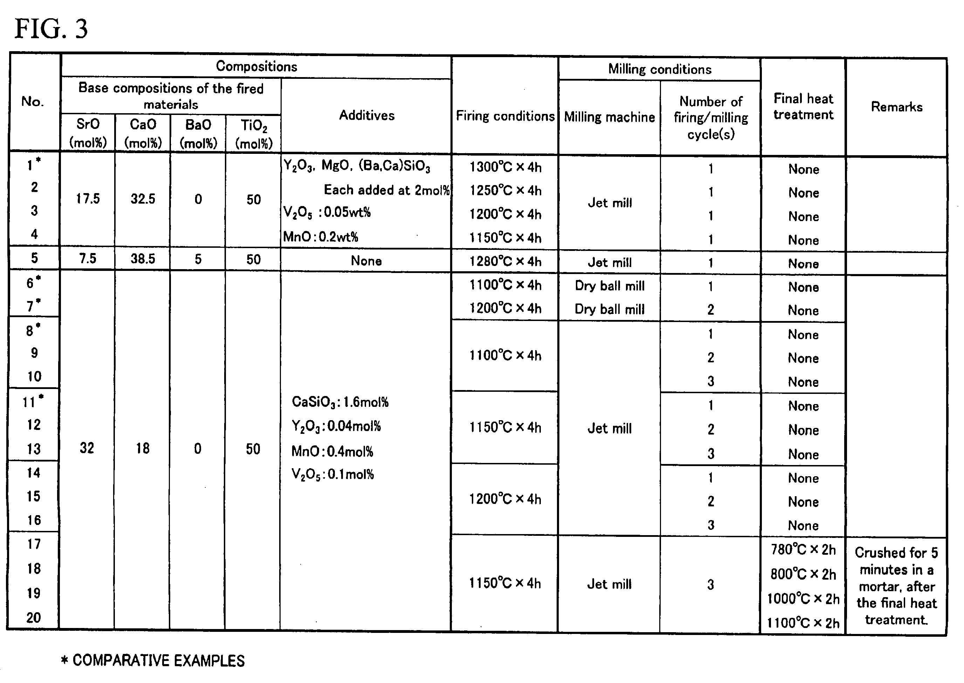

$SrCO_3$, $CaCO_3$, $BaCO_3$ and $TiO_2$ powders were prepared, and weighed to have the base compositions of the fired materials shown in FIG. 3. Each composition was treated by wet ball-milling for 16 hours to prepare the mixture of raw materials. It was calcined at 1200°C for 2 hours, additives shown in FIG. 3 were added to the calcined materials, and then treated by wet ball-milling for 16 hours. The milled powder was fired under the conditions shown in FIG. 3, preliminarily crushed in a mortar to pass through a mesh with 1 mm square openings, and then finely milled by a jet mill or dry ball mill, also shown in FIG. 3. In the column "firing/milling cycle number" in FIG. 3, "1" means that the powder was treated by one cycle of firing, crushingandmilling. Similarly, "2"and"3" mean that the cycles were repeated 2 and 3 times, respectively. In No.5 shown in FIG. 3, the base composition containing no additive was not calcined, and fired after it was treated by wet ball-milling. In No. 17 to 20 shown in FIG. 3, each of the compositions was milled, and then heat-treated (final heat treatment) which followed the final firing/milling cycle.

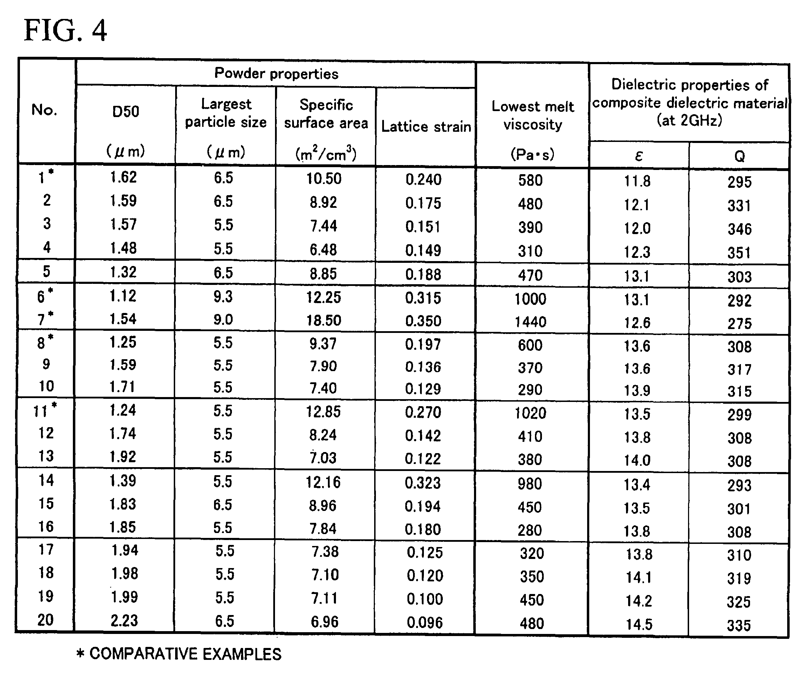

The dielectric ceramic powders prepared in EXAMPLE were analyzed for the powder properties shown in FIG. 4. Moreover, the product powders were incorporated with 40% by volume of vinyl benzyl resin, to measure their lowest melt viscosity. The composite dielectric materials of the dielectric ceramic powder and vinyl benzyl resin were analyzed for dielectric constant ($\varepsilon$) and Q value at a frequency of 2GHz. The results are summarized in FIG. 4.

Referring to the results of Nos. 1 to 5, shown in FIGS. 3 and 4, the same powder composition may have a specific surface area exceeding 9 $m^2/cm^3$ and lattice strain exceeding 0.2, i.e., beyond the range for the present invention, as firing temperature increases.

Comparing the results of Nos. 6 and 7 with those of the others, also shown in FIGS. 3 and 4, ball-milling may give a powder having a specific surface area above 9 $m^2/cm^3$, in spite of a high level of the largest particle. By contrast, it is found that a jet mill can easily give a powder having a specific surface area controlled at 9 $m^2/cm^3$ or less.

Referring to the results of Nos. 8 to 10, 11 to 13 and 14 to 16, the powders can have a specific surface area of 9 $m^2/cm^3$ or less and lattice strain of 0.2 or less, when they undergo two firing/milling cycles, although each of these values is beyond the range for the present invention when they undergo one cycle.

The results shown in FIG. 4 indicate that the lowest melt viscosity exceeds 500 Pa.s, when powder specific surface area exceeds 9 $m^2/cm^3$, to deteriorate fluidity of the mixture of dielectric ceramic powder and resin, and that dielectric properties, in particular Q value decreasing to below 300, when a powder lattice stain exceeds 0.2.

The heat treatment ("final heat treatment," described in FIG. 3) carried out subsequent to the milling step reduces a lattice strain to improve dielectric properties. The effect is more noted when it is carried out at 800°C or higher. Therefore, the heat treatment, when adopted, should be carried out at 800°C or higher.

The composite dielectric material for which the dielectric ceramic powder of the present invention is used has good dielectric properties, e.g., dielectric constant ($\varepsilon$) of 12 or more and Q value of 300 or more.

## Claims

1. A dielectric ceramic powder having a specific surface area of 9 $m^2/cm^3$ or less and a lattice strain of 0.2 or less, wherein said dielectric ceramic powder is a composite perovskite ceramic powder,
said composite perovskite ceramic powder is (Sr, Ca) $TiO_3$-based ceramic or (Ba, Sr, Ca) $TiO_3$-based ceramic;
said dielectric ceramic powder is composed of particles of indefinite shape produced by milling; and
said dielectric ceramic powder has the largest particle size of 10 $\mu$m or less.

2. The dielectric ceramic powder according to claim 1, wherein:

   said dielectric ceramic powder has a specific surface area of 8.5 $m^2/cm^3$ or less.

3. The dielectric ceramic powder according to claim 1, wherein:

   said dielectric ceramic powder has a lattice strain of 0.18 or less.

4. A method for producing a dielectric ceramic powder, comprising the steps of:

   firing a starting material at a given temperature level for a given time to obtain a fired material, and
   milling said fired material by a jet mill, wherein:

   each of said firing step and said milling step are carried out at least twice.

5. The method for producing a dielectric ceramic powder according to claim 4, wherein:

   said starting material is a calcined material obtained by calcining a mixture of raw materials.

6. The method for producing a dielectric ceramic powder according to claim 4, wherein:

   said starting material is fired at 1250°C or lower in said firing step.

7. The method for producing a dielectric ceramic powder according to claim 4, wherein:

   said milled powder produced in said milling step is heat-treated at 800 to 1200°C.

8. The method for producing a dielectric ceramic powder according to claim 4, wherein:

   Said dielectric ceramic powder has a specific surface area of 9 $m^2/cm^3$ or less and a lattice strain of 0.2 or less.

9. A composite dielectric material comprising:

   said dielectric ceramic powder according to claim 1, and
   a resin in which said dielectric ceramic powder is dispersed.

**10.** The composite dielectric material according to claim 9, wherein:

>   said composite dielectric material has dielectric constant at 2GHz of 12 or more and Q value at 2GHz of 300 or more.

**11.** The composite dielectric material according to claim 9, wherein:

>   said resin is vinyl benzyl resin.

**Patentansprüche**

**1.** Nicht leitendes keramisches Pulver mit einem spezifischen Oberflächenbereich vom 9 $m^2/cm^3$ oder weniger und einer Gitterverzerrung von 0,2 oder weniger, wobei
das nicht leitende keramische Pulver ein keramisches Perowskitverbundpulver ist,
das keramische Perowskitverbundpulver eine auf (Sr, Ca) $TiO_3$ basierende Keramik oder eine auf (Ba, Sr, Ca) $TiO_3$ basierende Keramik ist;
das nicht leitende keramische Pulver aus Partikeln mit unbestimmter Form zusammengesetzt ist, welche durch Mahlen hergestellt sind; und
das nicht leitende keramische Pulver eine größte Partikelgröße von 10 μm oder kleiner aufweist.

**2.** Nicht leitendes keramisches Pulver gemäß Anspruch 1, wobei:

>   das nicht leitende keramische Pulver einen spezifischen Oberflächenbereich von 8,5 $m^2/cm^3$ oder weniger aufweist.

**3.** Nicht leitendes keramisches Pulver gemäß Anspruch 1, wobei:

>   das nicht leitende keramische Pulver eine Gitterverzerrung von 0,18 oder weniger aufweist.

**4.** Verfahren zur Herstellung eines nicht leitenden keramischen Pulvers, umfassend die Schritte:

>   Brennen eines Startmaterials bei einem vorgegebenen Temperaturniveau über eine vorgegebene Zeit, um ein gebranntes Material zu erhalten, und
>   Mahlen des gebrannten Materials mittels einer Strahlmühle, wobei

>   sowohl der Brennschritt als auch der Mahlschritt zumindest zwei Mal ausgeführt werden.

**5.** Verfahren zur Herstellung eines nicht leitenden keramischen Pulvers gemäß Anspruch 4, wobei
das Startmaterial ein kalziniertes Material ist, das durch Kalzinieren einer Mischung von Rohmaterialien erhalten wurde.

**6.** Verfahren zur Herstellung eines nicht leitenden keramischen Pulvers gemäß Anspruch 4, wobei
das Startmaterial im Brennschritt bei 1250°C oder niedriger gebrannt wird.

**7.** Verfahren zur Herstellung eines nicht leitenden keramischen Pulvers gemäß Anspruch 4, wobei
das gemahlene Pulver, das im Mahlschritt erzeugt wurde, bei 800 bis 1200°C wärmebehandelt wird.

**8.** Verfahren zur Herstellung eines nicht leitenden keramischen Pulvers gemäß Anspruch 4, wobei
das nicht leitende keramische Pulver einen spezifischen Oberflächenbereich von 9$m^2/cm^3$ oder weniger sowie eine Gitterverzerrung von 0,2 oder weniger aufweist.

**9.** Nicht leitendes Verbundmaterial, umfassend:

>   das nicht leitende keramische Pulver gemäß Anspruch 1, und
>   einen Harz, in dem das nicht leitende keramische Pulver dispergiert ist.

**10.** Nicht leitendes Verbundmaterial gemäß Anspruch 9, wobei

das nicht leitende Verbundmaterial eine Dielektrizitätskonstante bei 2 GHz von 12 oder mehr sowie einen Q-Wert bei 2 GHz von 300 oder mehr aufweist.

**11.** Nicht leitendes Verbundmaterial gemäß Anspruch 9, wobei das Harz Venylbenzylharz ist.

## Revendications

**1.** Poudre de céramique diélectrique ayant une surface spécifique de 9 $m^2$ / $cm^3$ ou moins et une contrainte de réseau cristallin de 0,2 ou moins, dans laquelle
ladite poudre de céramique diélectrique est une poudre de céramique pérovskite composite,
ladite poudre de céramique pérovskite composite est une céramique à base de (Sr, Ca)$TiO_3$ ou une céramique à base de (Ba, Sr, Ca)$TiO_3$ ;
ladite poudre de céramique diélectrique est composée de particules de forme indéfinie produites par broyage ; et
ladite poudre de céramique diélectrique a une taille de particule la plus grande de 10 $\mu$m ou moins.

**2.** Poudre de céramique diélectrique selon la revendication 1, dans laquelle :

ladite poudre de céramique diélectrique a une surface spécifique de 8,5 $m^2$ / $cm^3$ ou moins.

**3.** Poudre de céramique diélectrique selon la revendication 1, dans laquelle :

ladite poudre de céramique diélectrique a une contrainte de réseau cristallin de 0,18 ou moins.

**4.** Procédé de production d'une poudre de céramique diélectrique, comprenant les étapes consistant à :

cuire une matière de départ à un niveau de température donné pendant un temps donné pour obtenir une matière cuite, et
broyer ladite matière cuite par un broyeur à tuyère, dans lequel :

chacune de ladite étape de cuisson et de ladite étape de broyage est effectuée au moins deux fois.

**5.** Procédé de production d'une poudre de céramique diélectrique selon la revendication 4, dans lequel :

ladite matière de départ est une matière calcinée obtenue en calcinant un mélange de matières premières.

**6.** Procédé de production d'une poudre de céramique diélectrique selon la revendication 4, dans lequel :

ladite matière de départ est cuite à 1 250 °C ou moins dans ladite étape de cuisson.

**7.** Procédé de production d'une poudre de céramique diélectrique selon la revendication 4, dans lequel :

ladite poudre broyée produite dans ladite étape de broyage subit un traitement thermique à 800 à 1 200 °C.

**8.** Procédé de production d'une poudre de céramique diélectrique selon la revendication 4, dans lequel :

ladite poudre de céramique diélectrique a une surface spécifique de 9 $m^2$ / $cm^3$ ou moins et une contrainte de réseau cristallin de 0,2 ou moins.

**9.** Matière diélectrique composite comprenant :

ladite poudre de céramique diélectrique selon la revendication 1, et
une résine dans laquelle ladite poudre de céramique diélectrique est dispersée.

**10.** Matière diélectrique composite selon la revendication 9, dans laquelle :

ladite matière diélectrique composite a une constante diélectrique à 2 GHz de 12 ou plus et une valeur Q à 2 GHz de 300 ou plus.

**11.** Matière diélectrique composite selon la revendication 9, dans laquelle :

ladite résine est une résine de benzyle de vinyle.

# FIG. 1

EP 1 541 537 B1

# FIG. 2

# FIG. 3

| No. | Base compositions of the fired materials SrO (mol%) | CaO (mol%) | BaO (mol%) | TiO$_2$ (mol%) | Additives | Firing conditions | Milling machine | Number of firing/milling cycle(s) | Final heat treatment | Remarks |
|---|---|---|---|---|---|---|---|---|---|---|
| 1* | 17.5 | 32.5 | 0 | 50 | Y$_2$O$_3$, MgO, (Ba,Ca)SiO$_3$ Each added at 2mol% V$_2$O$_5$ :0.05wt% MnO:0.2wt% | 1300°C × 4h | Jet mill | 1 | None | |
| 2 | | | | | | 1250°C × 4h | | 1 | None | |
| 3 | | | | | | 1200°C × 4h | | 1 | None | |
| 4 | | | | | | 1150°C × 4h | | 1 | None | |
| 5 | 7.5 | 38.5 | 5 | 50 | None | 1280°C × 4h | Jet mill | 1 | None | |
| 6* | 32 | 18 | 0 | 50 | CaSiO$_3$: 1.6mol% Y$_2$O$_3$:0.04mol% MnO:0.4mol% V$_2$O$_5$:0.1mol% | 1100°C × 4h | Dry ball mill | 1 | None | |
| 7* | | | | | | 1200°C × 4h | Dry ball mill | 2 | None | |
| 8* | | | | | | 1100°C × 4h | Jet mill | 1 | None | |
| 9 | | | | | | 1100°C × 4h | | 2 | None | |
| 10 | | | | | | 1100°C × 4h | | 3 | None | |
| 11* | | | | | | 1150°C × 4h | Jet mill | 1 | None | |
| 12 | | | | | | 1150°C × 4h | | 2 | None | |
| 13 | | | | | | 1150°C × 4h | | 3 | None | |
| 14 | | | | | | 1200°C × 4h | | 1 | None | |
| 15 | | | | | | 1200°C × 4h | | 2 | None | |
| 16 | | | | | | 1200°C × 4h | | 3 | None | |
| 17 | | | | | | 1150°C × 4h | Jet mill | 3 | 780°C × 2h | Crushed for 5 minutes in a mortar, after the final heat treatment. |
| 18 | | | | | | | | | 800°C × 2h | |
| 19 | | | | | | | | | 1000°C × 2h | |
| 20 | | | | | | | | | 1100°C × 2h | |

\* COMPARATIVE EXAMPLES

EP 1 541 537 B1

# FIG. 4

| No. | Powder properties | | | | Lowest melt viscosity | Dielectric properties of composite dielectric material (at 2GHz) | |
| | D50 | Largest particle size | Specific surface area | Lattice strain | | | |
| | ($\mu$m) | ($\mu$m) | (m$^2$/cm$^3$) | | (Pa·s) | $\varepsilon$ | Q |
|---|---|---|---|---|---|---|---|
| 1* | 1.62 | 6.5 | 10.50 | 0.240 | 580 | 11.8 | 295 |
| 2 | 1.59 | 6.5 | 8.92 | 0.175 | 480 | 12.1 | 331 |
| 3 | 1.57 | 5.5 | 7.44 | 0.151 | 390 | 12.0 | 346 |
| 4 | 1.48 | 5.5 | 6.48 | 0.149 | 310 | 12.3 | 351 |
| 5 | 1.32 | 6.5 | 8.85 | 0.188 | 470 | 13.1 | 303 |
| 6* | 1.12 | 9.3 | 12.25 | 0.315 | 1000 | 13.1 | 292 |
| 7* | 1.54 | 9.0 | 18.50 | 0.350 | 1440 | 12.6 | 275 |
| 8* | 1.25 | 5.5 | 9.37 | 0.197 | 600 | 13.6 | 308 |
| 9 | 1.59 | 5.5 | 7.90 | 0.136 | 370 | 13.6 | 317 |
| 10 | 1.71 | 5.5 | 7.40 | 0.129 | 290 | 13.9 | 315 |
| 11* | 1.24 | 5.5 | 12.85 | 0.270 | 1020 | 13.5 | 299 |
| 12 | 1.74 | 5.5 | 8.24 | 0.142 | 410 | 13.8 | 308 |
| 13 | 1.92 | 5.5 | 7.03 | 0.122 | 380 | 14.0 | 308 |
| 14 | 1.39 | 5.5 | 12.16 | 0.323 | 980 | 13.4 | 293 |
| 15 | 1.83 | 6.5 | 8.96 | 0.194 | 450 | 13.5 | 301 |
| 16 | 1.85 | 5.5 | 7.84 | 0.180 | 280 | 13.8 | 308 |
| 17 | 1.94 | 5.5 | 7.38 | 0.125 | 320 | 13.8 | 310 |
| 18 | 1.98 | 5.5 | 7.10 | 0.120 | 350 | 14.1 | 319 |
| 19 | 1.99 | 5.5 | 7.11 | 0.100 | 450 | 14.2 | 325 |
| 20 | 2.23 | 6.5 | 6.96 | 0.096 | 480 | 14.5 | 335 |

* COMPARATIVE EXAMPLES

EP 1 541 537 B1

**EP 1 541 537 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2617639 B
- JP 2003151352 A
- JP 2001187831 A